# EUROPÄISCHE PATENTSCHRIFT

(11) **EP 0 815 713 B1**
(45) Veröffentlichungstag und Bekanntmachung des Hinweises auf die Patenterteilung: **22.12.1999**
(21) Anmeldenummer: 96907510.0
(22) Anmeldetag: 25.03.1996
(51) Int. Cl.: H05K 13/04

(54) **VORRICHTUNG ZUM ABTRENNEN VON BAUELEMENTEN VON EINER UNTERLAGE, INSBESONDERE ZUM AUSLÖTEN VON ELEKTRONISCHEN BAUELEMENTEN**
DEVICE FOR SEPARATING COMPONENTS FROM A SUBSTRATE, IN PARTICULAR FOR UNSOLDERING ELECTRONIC COMPONENTS
PROCEDE PERMETTANT DE SEPARER LES COMPOSANTS D'UN SUBSTRAT, NOTAMMENT DE DESSOUDER DES COMPOSANTS ELECTRONIQUES

(30) Priorität: 24.03.1995 DE 19510985
(43) Veröffentlichungstag der Anmeldung: 07.01.1998
(73) Patentinhaber: IBL-Löttechnik GmbH, 86343 Königsbrunn (DE)
(72) Erfinder: ZABEL, Claus, D-86199 Augsburg (DE); LEICHT, Helmut, W., D-86343 Königsbrunn (DE)
(74) Vertreter: VOSSIUS & PARTNER
(86) Internationale Anmeldenummer: EP9601311
(87) Internationale Veröffentlichungsnummer: WO9631109

(56) Entgegenhaltungen:
- EP-A- 0 079 848
- DE-A- 1 943 393
- NL-A- 9 100 768

## Beschreibung

Die Erfindung bezieht sich auf eine Vorrichtung zum Abtrennen von Bauelementen von einer Unterlage, die mittels einer aufschmelzbaren Masse auf der Unterlage befestigt sind und insbesondere zum Auslöten von Bauelementen, insbesondere elektronischen Bauelementen die mit einem Träger, insbesondere einer Leiterplatte, durch ein Lot verbunden sind. Die Vcrrichtung hebt die Bauelemente mittels eines Greifers, der unter einer Vorspannung in Abheberichtung der Bauelemente von dem Träger steht, von diesem ab, wobei eine mit dem Greifer verbundene Abhebeeinrichtung bei Erreichen der Schmelztemperatur des Lots die Vorspannung wirksam werden läßt.

Eine derartige Vorrichtung ist in der DE-A-42 11 241 beschrieben. Bei dieser dient ein Greifer oder eine Klebevorrichtung als Abhebeeinrichtung, die durch eine Feder oder eine andere elastische Einrichtung vorgespannt ist. Die Feder übt auf das auszulötende Bauelement eine Zugkraft aus, die das Abheben des betreffenden Bauelementes dann bewirkt, wenn die Lötstellen, über die das Bauelement mit einer leiterplatte verbunden ist, zum Schmelzen gebracht worden sind. Bis zu diesem Zeitpunkt wirkt sich die Kraft der Feder voll auf das betreffende Bauelement aus, dessen gelötete Anschlüsse dabei entsprechend belastet werden, was dazu führen kann, daß diese Lötstellen, bevor ihr Lot aufgeschmolzen ist, abreißen und damit eine Zerstörung an dem Bauteil und an der Leiterplatte hervorrufen können.

Der Erfindung liegt die Aufgabe zugrunde, diese Gefahr zu beseitigen. Erfindungsgemäß geschieht dies dadurch, daß die Abhebeeinrichtung ein aus einer schmelzbaren Masse, z.B. einem Schmelzkleber oder einer lotartigen Metallegierung bestehendes Rückhalteglied enthält, dessen Schmelzpunkt gleich oder größer ist als der Schmelzpunkt der schmelzbaren Masse bzw. des Lots und das beim Schmelzen der Masse bzw. der Metallegierung das Abheben des Bauelements auslöst.

Obwohl die Erfindung im nachstehenden insbesondere anhand einer Vorrichtung zum Auslöten von Bauelementen beschrieben wird, die mittels einer lotartigen Metallegierung auf einem Träger befestigt sind, kann das erfindungsgemäße Prinzip in all den Fällen eingesetzt werden, wo die Befestigungsmasse, wie Klebstoff, einen bestimmten Schmelzpunkt hat und eine entsprechende Masse mit im wesentlichem gleichem oder höherem Schmelzpunkt bei dem Rückhalteglied eingesetzt wird.

Bei der Verwendung der lotartigen Metallegierung als Rückhalteglied läßt sich dessen Schmelzpunkt ohne besonderen Aufwand an den Schmelzpunkt des Lots anpassen, so daß mit dem Schmelzen des Lots und damit der Freigabe des betreffenden Bauelements sofort auch das Rückhalteglied zum Schmelzen gebracht wird, das damit das Abheben des Bauelements auslöst. Die auf die Abhebeeinrichtung wirkende Vorspannung, die mit dem Schmelzen des Rückhaltegliedes eine Bewegung der Abhebeeinrichtung auslöst, wird also erst nach dem Schmelzen des Lots wirksam, so daß die Vorspannung sich erst dann auf das Bauelement auswirken kann, wenn dieses durch das Schmelzen des Lots bereits vom Träger freigegeben worden ist. Es kommt also zu keinem Zeitpunkt zu einer Belastung des Bauelementes durch die Vorspannung, während das Bauelement noch über das harte Lot mit dem Träger verbunden ist. Wenn dabei eine lotartige Metallegierung für das Rückhalteglied verwendet wird, deren Schmelzpunkt gleich dem Schmelzpunkt des Lots ist z.B. bei Verwendung der gleichen Materialzusammensetzung, dann ergibt sich ebenfalls der Effekt des zuerst erfolgenden Aufschmelzens des Lots und danach das Schmelzens des Rückhaltegliedes, da bei der für das Auslöten erforderlichen Erhitzung diese sich im wesentlichen zunächst auf die Lötstellen der Bauelemente auswirkt und erst mit geringer Verzögerung in gleicher Weise bei dem Rückhalteglied wirksam wird, da dieses wegen seiner Verbindung mit der Abhebeeinrichtung von Bauteilen umgeben ist, die zunächst eine gewisse Wärmeabsorption bewirken. Liegt der Schmelzpunkt der lotartigen Metallegierung über demjenigen des Lots, so ergibt sich bei der Wärmezuführung zum Auslöten der Bauelemente automatisch zunächst das Schmelzen des Lots und erst danach das Schmelzen des Rückhaltegliedes, sofern natürlich die Wärmezufuhr für das Auslöten so gestaltet ist, daß dabei im Bereich der Bauelemente und der Abhebeeinrichtung eine Temperatur erreicht wird, die über dem Schmelzpunkt des Lots und mindestens bei dem Schmelzpunkt des Rückhaltegliedes liegt. Dies gilt z.B. bei der Verwendung einer Dampfphase zum Auslöten, wie dies in der oben erwähnten DE-A-42 11 241 erwähnt ist.

Im Falle eines Schmelzpunktes der lotartigen Metallegierung, der größer ist als der Schmelzpunkt des Lots, wählt man zweckmäßig den ersteren Schmelzpunkt nur unwesentlich höher, um damit eine Gefährdung der Bauelemente vor zu großer Erhitzung zu vermeiden. Vorteilhaft liegt der Schmelzpunkt der lotartigen Metallegierung etwa um einige Grad Celsius höher als der Schmelzpunkt des Lots.

Für die Ausbildung des Rückhaltegliedes gibt es verschiedene Möglichkeiten. Eine vorteilhafte Möglichkeit besteht darin, das Rückhalteglied als Stützteil für die Abhebeeinrichtung auszubilden. In diesem Falle wird die Abhebeeinrichtung solange durch das Stützteil festgehalten und kann somit auf das Bauteil keine Zugwirkung ausüben, wie das Rückhalteglied seinen Schmelzpunkt nicht erreicht hat. Mit Erreichen dieses Schmelzpunktes verliert dann das Stützteil seine Wirkung, so daß die Abhebeeinrichtung das Bauteil von dem Träger abheben kann. Das Stützteil bringt man zweckmäßig in einem offenen Behälter unter, aus dem es nach seinem Schmelzen und damit seiner Umformung in ein in diesem Zusammenhang unwirksames Metallegierungsteil ohne weiteres entnommen werden kann. Dieses Metallegierungsteil kann entweder weggeworfen oder durch Umschmelzen wieder verwendet werden. Für einen neuen Vorgang des Auslötens eines Bauelementes ist jedenfalls in den Behälter ein unverformtes Stützteil als Rückhalteglied einzusetzen.

Das Rückhalteglied kann man auch als Faden ausbilden, der zwischen der Abhebeeinrichtung und einem Halteteil eingespannt ist. In diesem Fall hält der Faden gegen die Vorspannung die Abhebeeinrichtung fest, bis der Faden schmilzt, woraufhin die Abhebeeinrichtung das Bauteil vom Träger abheben kann.

Eine weitere Möglichkeit der Ausbildung des Rückhaltegliedes besteht darin, dieses als Block auszubilden, in den ein an der Abhebeeinrichtung angelenkter Zuganker eintaucht. Für die Verbindung des Blockes mit dem Zuganker wird die lotartige Metallegierung zunächst aufgeschmolzen, woraufhin in die Schmelze der Zuganker eingetaucht wird. Danach läßt man die Schmelze zu dem Block erkalten, der dann den eingetauchten Zuganker festhält und damit die Abhebeeinrichtung solange blockiert, bis der Block schmilzt. Aus dem erschmolzenen Block kann aer Zuaanker dann unter der Wirkung der Vorspannung durch die Bewegung der Abhebeeinrichtung herausgezogen werden, womit das betreffende Bauelement abgehoben wird.

Eine weitere Mögichkeit der Ausbildung des Rückhaltegliedes besteht darin, diese nach Art eines Scherstiftes zu verwenden. Der ein bekanntes Bauelement bildende Scherstift wirkt dadurch, daß er durch fluchtende Löcher von zwei aneinander vorbei bewegten Bauteilen geschoben wird, wodurch der Scherstift die Bewegung der Bauteile verhindert. Erst wenn auf die Bauteile eine solche Kraft wirkt, daß der Scherstift dabei abgeschert wird, dann können sich die Bauteile gegeneinander verschieben. Im Falle der Verwendung als Rückhalteglied bedeutet dies, daß dieses nach Art eines Scherstiftes in fluchtende Löcher zweier aneinander vorbei bewegter Teile eingeschoben wird, wobei aber keine Abscherung des Stiftes erfolgt, sondern die Beweglichkeit der Bauteile dann eintritt, wenn der Stift zum Schmelzen gebracht wird. Bei den Bauteilen handelt es sich einerseits um ein Teil der Abhebeeinrichtung und ein irgendwie starr befestigtes Teil.

In vorteilhafter Weise kann die Schmelzmasse bzw. die lotartige Metallegierung des Rückhaltegliedes sich beim Aufschmelzen verlagern, z.B. abfließen, so daß unter Ausnutzung der Gravitation sich die Abhebeeinrichtung so bewegt, daß das Bauelement vom Träger abgehoben wird.

In diesem Fall müssen keine die Abhebebewegung auslösenden Federn eingesetzt werden. Im Rahmen der Erfindung ist es jedoch auch möglich, derartige Federn unterstützend neben der Gravitationskraft einzusetzen.

Die Abhebeeinrichtung bildet man zweckmäßig als Hebel aus, auf den die Vorspannung wirkt und mit dessen einem Ende der Greifer verbunden ist, von dem beabstandet das Rückhalteglied angelenkt ist. Bei dem Hebel kann es sich dabei sowohl um einen einarmigen als auch einen zweiarmigen Hebel handeln.

Ausführungsbeispiele der Erfindung sind in den Figuren dargestellt. Es zeigen
- Fig. 1: die Vorrichtung mit einem zweiarmigen Hebel und einem als Stützteil ausgebildeten Rückhalteglied in der Position vor dem Abheben des Bauteils;
- Fig. 2: die gleiche Vorrichtung mit erschmolzenen Stützteil und abgehobenem Bauteil;
- Fig. 3: eine ähnliche Vorrichtung mit einem einarmigen Hebel und einem als Faden ausgebildeten Rückhalteglied;
- Fig. 4: eine Vorrichtung mit einem einarmigen Hebel und einem als Block ausgebildeten Rückhalteglied;
- Fig. 5: ein als Scherstift ausgebildetes Rückhalteglied;
- Fig. 6: eine Vorrichtung mit abfließender Schmelzmasse und
- Fig. 7: eine Vorrichtung mit sich verlagernder Schmelzmasse.

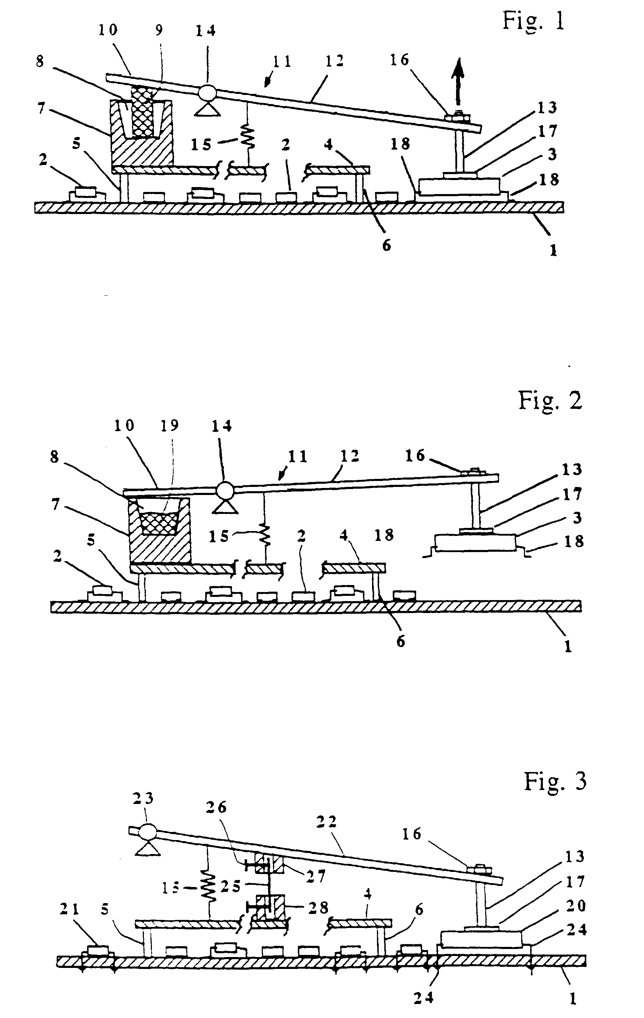

In der Figur 1 ist eine Schaltungsplatte 1 mit daran angelöteten Bauteilen 2 und 3 dargestellt, wobei es sich bei den Bauteilen 2 und 3 um in beliebiger bekannter Weise an einer Leiterplatte anlötbare Bauteile handelt, z.B. Widerstände, Transistoren, integrierte Schaltkreise bzw. Chips und dergleichen. Bei dem Bauelement 3 handelt es sich hier um ein größeres Bauteil, das z.B. durch einen integrierten Schaltkreis gebildet sein kann. Wie ersichtlich, sind die Bauteile 2 und 3 entweder flächig an der Leiterplatte 1 oder über von ihnen abstehende Anschlüsse an der Leiterplatte 1 angebracht.

Auf die Leiterplatte 1 ist das Gestell 4 mit seinen Stützen 5 und 6 aufgesetzt, und zwar so, daß die Stützen 5 und 6 direkt auf freien Bereichen der Leiterplatte 1 aufsetzen. Das Gestell 4 trägt den Behälter 7, der einen sich nach außen konisch erweiternden Hohlraum 8 aufweist, in den das Stützteil 9 eingesetzt ist. Auf diesem Stützteil stützt sich der Hebelarm 10 des zweiarmigen Hebels 11 ab, der außerdem den zweiten Arm 12 aufweist, an dem die Abhebeeinrichtung 13 angelenkt ist. Der zweiarmige Hebel 11 ist auf der Drehachse 14 gelagert, die in beliebiger Weise stationär angebracht sein kann, wie dies in Figur 1 dargestellt ist. Es ist aber natürlich auch möglich, die Drehachse 14 an dem Gestell 4 anzubringen. Auf den Hebelarm 12 wirkt die Druckfeder 15, die sich mit ihrer einen Seite gegen das Gestell 4 und mit ihrer anderen Seite gegen den Hebelarm 12 abstützt und damit dem zweiarmigen Hebel 11 eine Vorspannung gibt, durch die der Hebelarm 12 mit der Abhebeeinrichtung 13 in der durch den Pfeil neben der Abhebeeinrichtung 13 angedeuteten Abheberichtung vorgespannt wird. Die Abhebeeinrichtung 13 ist über die an ihr befestigte Scheibe 16 gegenüber dem Hebelarm 12 so gesichert, daß sich die Abhebeeinrichtung 13 gegenüber dem Hebelarm 12 in gewissem Umfang verschwenken läßt. An ihrem der Scheibe 16 abgewandten Ende besitzt die Abhebeeinrichtung 13 die Abhebeplatte 17, an der hier das Bauelement 3 angeklebt ist. Die Abhebeplatte 17 wirkt hier also als der Greifer einer durch den zweiarmigen Hebel 11 gebildeten Abhebeeinrichtung. Für die Ausbildung dieses Greifers kommen natürlich auch weitere bekannte Ausführungsformen in Frage, wie beispielsweise ein Magnet, eine Saugplatte oder auch ein als Zange ausgebildeter Greifer und dergleichen.

Das Stützteil 9 ist hier als Stab ausgebildet, der aus einer einem Lot ähnlichen Metallegierung besteht, dessen Schmelzpunkt wenig oberhalb des Schmelzpunkts des Lots liegt, (z.B. 190° und 185°) mit dem die Bauteile 2,3 an der Leiterplatte 1 in bekannter Weise angelötet sind. In der in der Figur 1 dargestellten Position nimmt das Stützteil 9 die von der Druckfeder 15 ausgeübte Kraft auf, so daß die Abhebeeinrichtung 13 keine Zugkraft auf das Bauteil 3 ausüben kann, das heißt, die Anschlüsse 18 des Bauteils 3 unterliegen keiner Zugbelastung.

Um das Bauteil 3 auszulöten, wird die in Figur 1 dargestellte Anordnung erhitzt, z.B. in einer Dampfphase, deren Temperatur oberhalb des Schmelzpunkts des die Anschlüsse 18 an der Leiterplatte 1 haltenden Lots und des Stützteils 9 ist. Aufgrund der Erhitzung schmilzt dann zunächst das die Anschlüsse 18 haltende Lot, wodurch das Bauteil 3 gegenüber der Leiterplatte 1 freigegeben wird. Es folgt dann mit zunehmender Erwärmung der gesamten Anordnung auch das Schmelzen des Stützteils 9, das dabei in sich zusammensinkt und in die in Figur 2 dargestellte geschmolzene Form in den Behälter 7 übergeht. Dabei sinkt also das Stützteil 9 in sich zusammen, wodurch sich die Druckkraft der Druckfeder 15 auswirken kann und damit den zweiarmigen Hebel in die in Figur 2 dargestellte Lage verdreht. Dabei nimmt der Hebelarm 12 über die Abhebeeinrichtung 13 und die Abhebeplatte 17 das Bauteil 3 mit, dessen Lötverbindungen, wie oben dargelegt, bereits vorher abgeschmolzen waren. Auf diese Weise wird das Bauteil 3 von der Leiterplatte 1 entfernt, ohne das dabei zwischen dem Bauteil 3 mit seinen Anschlüssen 18 und der Leiterplatte 1 irgendwelche Spannungen auftreten können. Das in dem Behälter 7 enthaltene erschmolzene Material des Stützteils 9 bildet nach Erkalten den Kuchen 19, der entweder weggeworfen oder zur Neuformung eines Stützteils wieder verwendet werden kann.

Die in der Figur 3 dargestellte Variante gegenüber der Ausführungsform gemäß Figuren 1 und 2 weist den einarmigen Hebel 22 auf, der einseitig auf der Drehachse 23 gelagert ist. Diese Lagerung entspricht im Prinzip derjenigen, wie sie bei der Anordnung gemäß den Figuren 1 und 2 verwendet ist. An dem der Drehachse 23 abgewandten Ende des Hebels 22 ist wie beim Ausführungsbeispiel gemäß den Figuren 1 und 2 die Abhebeeinrichtung 13 angelenkt, an der über die Abhebeplatte 17 das Bauteil 20 angeklebt ist. Bei dem Bauteil 20 handelt es sich hier wieder um einen integrierten Schaltkreis, der allerdings mittels durch die Leiterplatte 1 hindurchgeführter Anschlüsse 24 an der Leiterplatte angelötet ist, und zwar auf der dem Bauteil 20 abgewandten Seite. Hierbei handelt es sich ebenfalls um eine bekannte Verbindungsart zwischen Bauteil und Leiterplatte. Das weiterhin dargestellte Bauteil 21 ist ebenfalls über durch die Leiterplatte 1 hindurchgesteckte Anschlüsse mit der Leiterplatte 1 verbunden.

Auf den Hebel 22 wirkt die Druckfeder 15, deren Kraft in Der in Figur 3 dargestellten Position durch der Faden 25 aufgefangen wird. Bei diesem Faden handelt es sich wieder wie beim Ausführungsbeispiel gemäß den Figuren 1 und 2 um das aus einer Metallegierung bestehende Rückhalteglied, bei dessen Schmelzen sich die Kraft der Feder 15 auswirken kann, da in diesem Falle der Faden 25 die durch ihn hergestellte Verbindung löst. Der Faden 25 ist mit seinem einen Ende mittels der prinzipiell dargestellten Schraube 26 an der Aufnahme 27 befestigt, die an dem Hebel 22 angebracht ist. Mit seinem anderen Ende ist der Faden 25 in entsprechender Weise an der Aufnahme 28 befestigt, die mit dem Gestell 4 verbunden ist.

Wenn die Anordnung gemäß Figur 3 in ähnlicher Weise, wie dies im Zusammenhang mit den Fig. 1 und 2 beschrieben ist, erhitzt wird, dann erfolgt zunächst das Aufschmelzen des Lots an den Anschlüssen 24, wodurch das Bauteil 20 freigegeben wird. Danach schmilzt dann auch der Faden 25, womit sich die Druckkraft der Druckfeder 15 auswirken kann und damit den Hebel 22 um die Achse 23 verdreht. Dabei wird dann, wie dies aus Figur 2 im Prinzip ersichtlich ist, das Bauteil 20 von der Leiterplatte 1 abgehoben. Diese Position ist im Zusammenhang mit der Anordnung gemäß Figur 3 nicht dargestellt, es kann jedoch hierzu auf die Darlegungen im Zusammenhang mit der Figur 2 verwiesen werden.

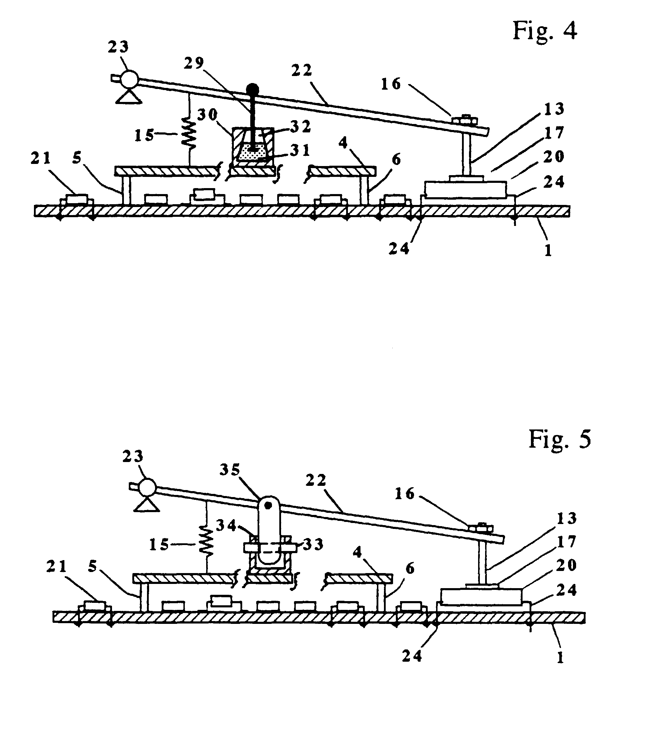

Bei der Figur 4 handelt es sich um eine Abwandlung der Anordnung gemäß der Figur 3, und zwar dahingehend, daß hier die Druckkraft der Feder 15 von dem Zuganker 29 aufgefangen wird, der an dem Hebel 22 angelenkt ist. Der Zuganker 29 ist in den Block 31 eingeschmolzen, der wie bei den vorstehend genannten Ausführungsbeispielen aus einer einem Lot ähnlichen Metallegierung besteht. Der Behälter 30 besitzt die sich nach außen verengende Öffnung 32, die verhindert, daß der sich In festem Zustand befindliche Block 31 aus dem Behälter 30 herausgezogen werden kann, wodurch dann auch der Zuganker 29 festgehalten wird. Der Behälter 30 ist wie der Behälter 7 gemäß den Figuren 1 und 2 an dem Gestell 4 befestigt.

Wenn die in der Figur 4 dargestellte Anordnung erhitzt wird, dann ergibt sich der gleiche Effekt wie bei der Anordnung gemäß Figur 3, es wird durch Aufschmelzen des Blocks 31 der Anker 29 freigegeben, so daß sich die Druckkraft der Druckfeder 15 auf den Hebel auswirken und damit das Bauteil 20 von der Leiterplatte 1 abheben kann, dessen Lötverbindungen vorher schon erschmolzen worden waren.

Eine weitere Variante zu den Anordnungen gemäß den Figuren 3 und 4 zeigt die Figur 5, bei der das Rückhalteglied nach Art eines Scherstiftes 33 ausgebildet ist. Der Scherstift 33 durchsetzt die Wandungen des Halters 34 und eine Bohrung in der Lasche 35, die ähnlich dem Anker 29 gemäß Figur 4 an dem Hebel 22 angelenkt ist. Der Scherstift 33 besteht als Rückhalteglied wieder aus der vorstehend beschriebenen Metallegierung, die bei Erhitzung der Anordnung nach dem Aufschmelzen des Lots für die Verbindungen der Bauteile ebenfalls schmilzt und damit das Herausziehen der Lasche 35 aus dem Halter 34 ermöglicht. Damit kann sich die Druckkraft der Druckfeder 15 auswirken und, wie dies im Zusammenhang mit den Figuren 3 und 4 beschrieben ist, das Bauteil 20 von der Leiterplatte abheben.

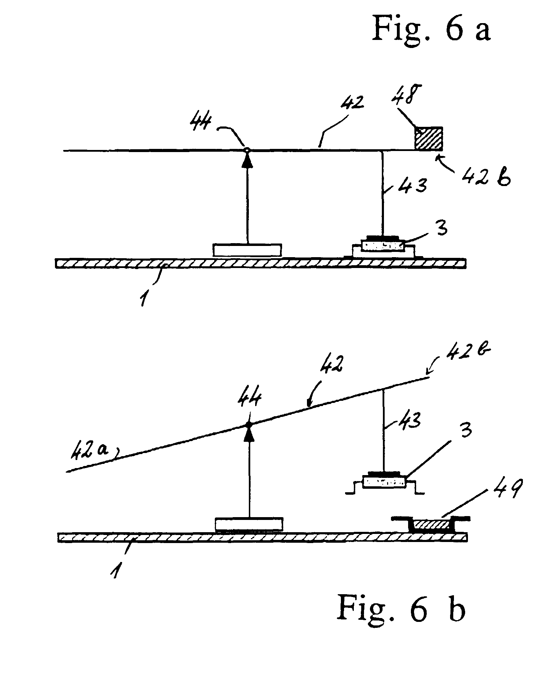

Bei der in Fig. 6a und b schematisch dargestellten Ausführungsform weist die Vorrichtung einen an einer Drehachse 44 gelagerten Hebel 42 auf, an dessen einem (in der Zeichnung rechten) Ende 42b die schmelzbare Masse 48 angebracht ist. Zwischen der Drehachse 44 und der schmelzbaren Masse 48 ist die Abhebeinrichtung 43 angelenkt. Bei ausreichender Temperaturerhöhung schmilzt die Masse 48 und fließt in einen Auffangbehälter 49 ab. Dadurch wird bei geeignet gewähltem Gegengewicht des linken Hebelabschnitts 42a der Hebel 42 nach dem Aufschmelzen des Befestigungsmaterials (z.B. Lot) des Bauelements gemäß Fig. 6b verschwenkt und das Bauelement 3 vom Träger 1 abgehoben.

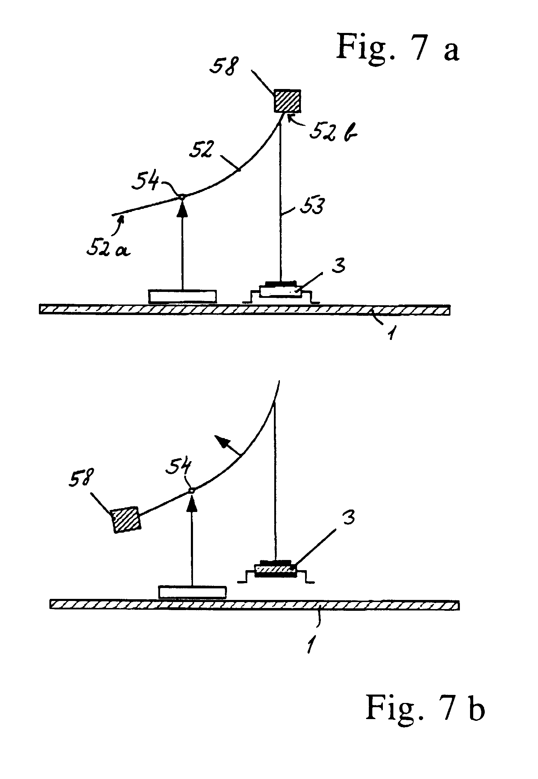

Bei der Ausführungsform gemäß Fig. 7 fließt bei ausreichender Temperaturerhöhung die aufschmelzende Masse 58 auf einem z.B. rinnenförmig ausgebildeten Hebel 52 (der eine Drehachse 54 aufweist) von dem erhöhten Endabschnitt 52b zum tiefer liegenden Endabschnitt 52a ab. Durch diese Gewichtsverlagerung übt der Hebel 52 über die Abhebeeinrichtung 53 auf das Bauelement eine vertikale Zugkraft aus, und bei aufgeschmolzener Befestigungsmasse des Bauelements 3 wird dieses von dem Träger abgehoben.

## Patentansprüche

1. Vorrichtung zum Abtrennen von Bauelementen (3,20), insbesondere elektronischen Bauelementen, die mit einem Träger, insbesondere einer Leiterplatte (1), durch eine Befestigungsmasse verbunden sind und mittels eines Greifers (17), der unter einer Vorspannung in Abheberichtung der Bauelemente (3,20) von dem Träger steht, von diesem abhebbar sind, wobei eine mit dem Greifer (17) verbundene Abhebeeinrichtung (13) bei Erreichen der Schmelztemperatur der Befestigungsmasse die Vorspannung wirksam werden läßt, dadurch gekennzeichnet, daß die Abhebeeinrichtung (13) ein aus einer schmelzbaren Masse bestehendes Rückhalteglied (9,25,31,33) enthält, dessen Schmelzpunkt gleich oder größer ist als der Schmelzpunkt der Befestigungsmasse und das beim Schmelzen der schmelzbaren Masse das Abheben des Bauelements (3,20) auslöst.

2. Vorrichtung nach Anspruch 1, dadurch gekennzeichnet, daß das Rückhalteglied als Stützteil (9) für die Abhebeeinrichtung (13) ausgebildet ist.

3. Vorrichtung nach Anspruch 2, dadurch gekennzeichnet, daß das Stützteil (9) von einem offenen Behälter (7) aufgenommen ist, aus dem das durch das Schmelzen entstandene Teil aus der schmelzbaren Masse entnehmbar ist.

4. Vorrichtung nach Anspruch 1, dadurch gekennzeichnet, daß das Rückhalteglied als Faden (25) ausgebildet ist, der zwischen der Abhebeeinrichtung (22,13) und einem Halteteil (28) eingespannt ist.

5. Vorrichtung nach Anspruch 1, dadurch gekennzeichnet, daß das Rückhalteglied als Block (31) ausgebildet ist, in den ein an der Abhebeeinrichtung (22) angelenkter Zuganker (29) eintaucht.

6. Vorrichtung nach Anspruch 1, dadurch gekennzeichnet, daß das Rückhalteglied als Scherstift (33) ausgebildet ist.

7. Vorrichtung nach Anspruch 1, dadurch gekennzeichnet, daß das Rückhalteglied durch örtliche Verlagerung nach dem Aufschmelzen unter Ausnutzung der Gravitation eine Hebelschwenkbewegung zum Abheben des Bauelements auslöst.

8. Vorrichtung nach Anspruch 7, dadurch gekennzeichnet, daß die schmelzbare Masse (49) des Rückhalteglieds beim Aufsetzen abfließt.

9. Vorrichtung nach Anspruch 7 oder 8, dadurch gekennzeichnet, daß die schmelzbare Masse (58) des Rückhalteglieds in eine Auffangwanne (49) oder entlang des Hebels (52) abfließt.

10. Vorrichtung nach einem der Ansprüche 1 bis 9, dadurch gekennzeichnet, daß die Abhebeeinrichtung als Hebel (11,22) ausgebildet ist, auf den die Vorspannung wirkt und mit dessen einem Ende der Greifer (17) verbunden ist, von dem beabstandet das Rückhalteglied (9,25,31,33) angelenkt ist.

11. Vorrichtung nach einem der Ansprüche 1 bis 10, dadurch gekennzeichnet, daß als schmelzbare Masse des Rückhaltegliedes eine lotartige Masse oder ein Schmelzkleber vorgesehen ist.

## Claims

1. Device for separating components (3, 20), in particular electronic components which are connected to a support, in particular a circuit board (1), by a fixing material and can be lifted from the support by means of a gripping element (17) under a preloaded force acting in the direction in which the components (3, 20) can be lifted from the support, wherein a lifting device (13) connected to the gripping element (17) causes the preloaded force to become effective when the fixing material reaches its melting temperature, characterized in that the lifting device (13) is provided with a retaining member (9, 25, 31, 33) made of a fusible material, whose melting temperature is equal to or higher than that of the fixing material and which triggers the action of lifting the component (3, 20) when the fusible material melts.

2. The device of claim 1, characterized in that said retaining member is formed as a supporting member (9) for the lifting device (13).

3. The device of claim 2, characterized in that said supporting member (9) is contained in an open container (7) from which the component made of the fusible material and formed by the melting process can be lifted.

4. The device of claim 1, characterized in that said retaining member is formed as a thread (25) clamped between said lifting device (22, 13) and a holding means (28).

5. The device of claim 1, characterized in that said retaining member is formed as a block (31) into which a tension rod (29) hinged to said lifting device (22) immerses.

6. The device of claim 1, characterized in that said retaining member is formed as a shearing pin (33).

7. The device of claim 1, characterized in that by means of local displacement after melting and by using the gravitational force said retaining member triggers a swiveling movement of the lever for lifting the component.

8. The device of claim 7, characterized in that the fusible material (49) of said retaining member flows off when melting.

9. The device of claim 7 or 8, characterized in that the fusible material (58) of said retaining member flows into a collecting basin (49) or along the lever (52).

10. The device of any one of claims 1 to 9, characterized in that said lifting device is formed as a lever (11, 22), the preloaded force acting on said lever and the one end of said lever being connected with said gripper (17) which is spacedly hinged to said retaining member (9, 25, 31, 33).

11. The device of any one of claims 1 to 10, characterized in that a material similar to a solder or a fusion adhesive is provided as the fusible material of said retaining member.

## Revendications

1. Dispositif de séparation d'éléments constructifs (3, 20), en particulier d'éléments constructifs électroniques qui sont fixés sur un support, en particulier une carte à circuits imprimés (1), à l'aide d'une masse de fixation et qui peuvent être soulevés de celui-ci à l'aide d'un grappin (17), qui est sous l'action d'une tension préalable dans la direction de soulèvement des éléments constructifs (3, 20) par rapport au support, un dispositif de soulèvement (13) relié au grappin (17) laissant la tension préalable devenir active lorsque la température de fusion de la masse de fixation est atteinte, caractérisé en ce que le dispositif de soulèvement (13) contient un élément de retenue (9, 25,31, 33) formé d'une masse fusible, dont le point de fusion est égal ou supérieur au point de fusion de la masse de fixation et qui déclenche le soulèvement de l'élément constructif (3, 20) lors de la fusion de la masse fusible.

2. Dispositif suivant la revendication 1, caractérisé en ce que l'élément de retenue est conçu comme pièce de support (9) pour le dispositif de soulèvement (13).

3. Dispositif suivant la revendication 2, caractérisé en ce que la pièce de support (9) est disposée dans un récipient ouvert (7), duquel la partie de la masse fusible formée lors de la fusion peut être retirée.

4. Dispositif suivant la revendication 1, caractérisé en ce que l'élément de retenue est conçu comme fil (25), qui est tendu entre le dispositif de soulèvement (22, 13) et une pièce de retenue (28).

5. Dispositif suivant la revendication 1, caractérisé en ce que l'élément de retenue est conçu comme bloc (31), dans lequel plonge un tirant d'ancrage (29) articulé au dispositif de soulèvement (22).

6. Dispositif suivant la revendication 1, caractérisé en ce que l'élément de retenue est conçu comme goujon de cisaillement (33).

7. Dispositif suivant la revendication 1, caractérisé en ce que l'élément de retenue déclenche un mouvement de levier pour le soulèvement de l'élément constructif par déplacement local après la fusion avec mise à profit de la gravitation.

8. Dispositif suivant la revendication 7, caractérisé en ce que la masse fusible (49) de l'élément de retenue s'écoule lors de la fusion.

9. Dispositif suivant la revendication 7 ou 8, caractérisé en ce que la masse fusible (58) de l'élément de retenue s'écoule dans un récipient de retenue (49) ou le long du levier (52).

10. Dispositif suivant l'une des revendications 1 à 9, caractérisé en ce que le dispositif de soulèvement est conçu comme levier (11, 22), sur lequel agit la tension préalable et à l'extrémité duquel est relié le grappin (17), auquel l'élément de retenue (9, 25, 31, 33) est articulé à distance.

11. Dispositif suivant l'une des revendications 1 à 10, caractérisé en ce qu'on prévoit comme masse fusible de l'élément de retenue une masse semblable à du plomb ou une colle fusible.
